(19) Europäisches Patentamt / European Patent Office / Office européen des brevets

(11) **EP 3 503 692 B1**

(12) **EUROPEAN PATENT SPECIFICATION**

(45) Date of publication and mention
of the grant of the patent:
**22.02.2023 Bulletin 2023/08**

(21) Application number: **16914143.9**

(22) Date of filing: **22.08.2016**

(51) International Patent Classification (IPC):
*H05H 1/26* (2006.01)  *A61N 1/44* (2006.01)
*H05H 1/24* (2006.01)  *H01J 37/32* (2006.01)

(52) Cooperative Patent Classification (CPC):
**H01J 37/32981; H05H 1/2418; H05H 1/2443;**
H05H 2245/34

(86) International application number:
**PCT/JP2016/074422**

(87) International publication number:
**WO 2018/037468 (01.03.2018 Gazette 2018/09)**

(54) **PLASMA IRRADIATION DEVICE AND PLASMA IRRADIATION METHOD**

PLASMASTRAHLUNGSVORRICHTUNG UND PLASMASTRAHLUNGSVERFAHREN

DISPOSITIF D'IRRADIATION DE PLASMA ET PROCÉDÉ D'IRRADIATION DE PLASMA

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(43) Date of publication of application:
**26.06.2019 Bulletin 2019/26**

(73) Proprietor: **Fuji Corporation
Chiryu-shi, Aichi 472-8686 (JP)**

(72) Inventors:
• **HIGASHIDA, Akihiro
Chiryu-shi
Aichi 472-8686 (JP)**
• **JINDO, Takahiro
Chiryu-shi
Aichi 472-8686 (JP)**

(74) Representative: **Grünecker Patent- und
Rechtsanwälte
PartG mbB
Leopoldstraße 4
80802 München (DE)**

(56) References cited:
**EP-A1- 1 933 608        EP-A1- 3 054 032
DE-A1-102013 113 941   JP-A- 2002 241 947
JP-A- 2004 253 647      JP-A- 2005 174 879
JP-A- 2006 313 669      JP-A- 2007 141 644
JP-A- 2008 130 503      JP-A- 2010 244 948
JP-A- 2015 195 113      KR-A- 20090 049 919
US-A1- 2015 236 359**

## Description

Technical Field

The present invention relates to a plasma emitting device and a plasma emitting method, in particular, to a plasma emitting device and a plasma emitting method capable of adjusting an atmosphere surrounding a plasma emission port when emitting plasma.

Background Art

With a plasma emitting device, plasma processing is performed by ejecting plasma from an emission port towards an application target such that plasma is applied to the application target (refer to patent literature 1).

Further examples of plasma emitting devices are known from patent literature 3-5.

Recently, research has been performed for using a plasma emitting device for medical treatment such as stopping bleeding. For a medical-use plasma emitting device, there is a danger of electrical discharge occurring to a person as an application target. Therefore, there is a known plasma application processing device capable of easily and reliably starting plasma generation and of stably maintaining a mild plasma jet without fluctuation.

Citation List

Patent Literature

Patent literature 1: International publication WO2013/108797
Patent literature 2: International publication WO2012/005132
Patent Literature 3: Japanese publication JP 2002-241947 A
Patent Literature 4: German publication DE 10 2013 113 941 A1
Patent Literature 5: European publication EP 3 054 032 A1

Summary of Invention

Technical Problem

As an example of medical treatment using a medical-use plasma emitting device, because oxygen plasma generated when using oxygen as an active gas is effective for killing cells, there are hopes for treatment of cancerous cells. Also, for example, because hydrogen plasma generated by using hydrogen as an active gas is effective for regenerating cells, by applying hydrogen plasma to skin, there are hopes for use in skin regeneration treatment.

It is thought that plasma can be used for medical treatment because the reactive agents such as free radicals generated by plasma interact with living tissue to produce useful effects, but the details of this mechanism are not yet fully understood. Therefore, to better understand the principles behind experiments are accumulated therapy, it is desirable to apply a constant level of plasma to an application target.

However, for example, for a hand-operated plasma emitting device such as that disclosed in patent literature 2, the plasma emission port through which the plasma is ejected to the application target is exposed to the atmosphere. Therefore, oxygen in the atmosphere may interfere when the plasma is emitted, meaning that it is difficult to control the emitted plasma to a constant level.

The above problem may be solved by surrounding the emitted plasma gas with a shield gas as disclosed in patent literature 1. However, to emit a shield gas it is necessary to provide a gas path for the shield gas and to control emission speed of the shield gas to be faster than that of the plasma gas. This means the device becomes larger and more complex, making it less easy to apply to a medical-use plasma emitting device. Another solution is represented by the device of patent literature 3. However this device requires a coil to drive the plasma making the system very complex.

The present invention takes account of such problems and an object thereof is to provide a plasma emitting device capable of controlling plasma emitted to a target body to a constant level while having a simple configuration.

Solution to Problem

To solve the above problems, a first aspect of the present invention provides a plasma emitting device according to claim 1. A second aspect of the present invention provides plasma application method according to claim 5. This second aspect neither covers therapeutic nor surgical methods performed on the human or animal body.

Preferred embodiments of the present invention are defined in the dependent claims.

Advantageous Effects

With a plasma emitting device of the present invention, a plasma emission port is arranged inside a container and an atmosphere inside the container is measured with a gas sensor. Therefore, because it is possible to always maintain the atmosphere inside the container at a given level when emitting plasma, the amount of plasma applied to the application target is controlled to a constant level.

Further, with a plasma emitting method of the present invention, because an oxygen concentration in the container is lowered by emitting inactive gas into the container and the plasma is ejected after the oxygen concentration inside the container has reached a desired value, the amount of plasma applied to the application target is controlled to a constant level.

Brief Description of Drawings

Fig. 1 is a cross section showing a plasma emitting device.

Fig. 2 is an exploded view of a plasma ejecting device.

Fig. 3 is a cross section showing of an example of a plasma emitting device.

Fig. 4 is a block diagram showing a control device.

Figs. 5(A) to (C) show examples of the interval adjusting mechanisms used in the device of the present invention and which are for adjusting the interval between the application target and the plasma emission port.

Fig. 6 is a cross section showing another plasma emitting device.

Description of Preferred Embodiments

Example embodiments of the present invention are described in detail below referring to the figures.

Configuration of plasma emitting device

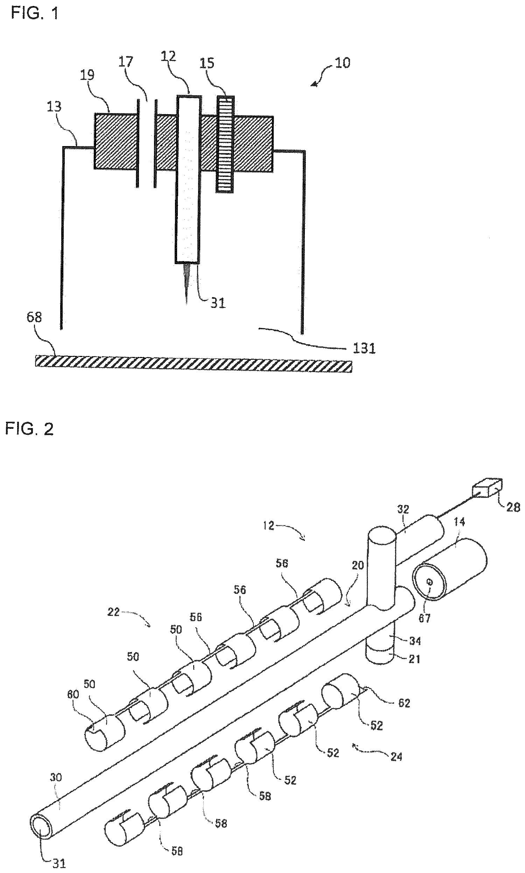

Fig. 1 shows a plasma emitting device. Plasma emitting device 10 of fig. 1 includes at least plasma ejecting device 12, container 13 arranged such that at least plasma emission port 31 of plasma ejecting device 12 is inside container 13; and gas sensor 15 configured to measure an atmosphere inside container 13. Plasma emitting device 10 shown in fig. 1 also includes plasma ejecting device 12, and plasma ejecting device 12, gas sensor 15, and gas ejection hole 17 are attached piercing through container attachment frame 19, and container 13 is attached so as to seal around container attachment frame 19. Opening section 131 that opens in a direction in which plasma is ejected from plasma ejecting device 12 is formed in container 13 of plasma emitting device 10 of the embodiment shown in fig. 1, therefore opening section 131 of container 131 is able to cover application target 68 and to emit plasma to application target 68.

The configuration of plasma ejecting device 12 is not particularly restricted, so long as it can eject plasma. Fig. 2 is an exploded view of plasma ejecting device 12. Plasma ejecting device 12 shown in fig. 2 is provided with at least pair of electrodes 22 and 24, and processing gas supply device 28. Main body section 20, for example, is formed from sapphire glass and is configured from cylindrical section 30, bent section 32, and dividing section 34. Cylindrical section 76 is substantially a round tube with plasma emission port 31 formed at one end. Bent section 32 is a tube bent into an L-shape, and an end section thereof is connected in an upright state to an outer surface of cylindrical section 30 near the other end of cylindrical section 30. The inside of cylindrical section 30 and the inside of bent section 32 are linked. Dividing section 34 is a short cylinder and is connected in an upright state to cylindrical section 30 on the opposite side to bent section 32. The inside of cylindrical section 30 and the inside of dividing section 34 are linked. Light receiving element 21 is arranged on the lower end of dividing section 34. Light receiving element 21, to be described in detail later, functions as a light receiving sensor, and a distance between application target 68 and plasma emitting device 10 is calculated based on the received light.

Multiple electrical discharge sections 50 and 52 of a pair of electrodes 22 and 24 are vacuum deposited on the outer circumferential surface of cylindrical section 30 of main body 20 so as to be lined up alternately in an axis direction of cylindrical section 30. In detail, electrode 22 includes multiple electrical discharge sections 50 and multiple connecting sections 56, and electrode 24 includes multiple electrical discharge sections 52 and multiple connecting sections 58. Note that, fig. 2 is a theoretical view showing electrodes 22 and 24 removed from cylindrical section 30.

The multiple electrical discharge sections 50 of electrode 22 are vacuum deposited on the outer circumferential surface of cylindrical section 30 extending in the circumferential direction, and are arranged at a specified interval lined up in the axis direction of cylindrical section 30. Also, connecting sections 56 of electrode 22 are vacuum deposited on the outer circumferential surface of cylindrical section 30 extending in a line in the axis direction of cylindrical section 30, and are connected to the multiple electrical discharge sections 50. Note that, from among the multiple electrical discharge sections 50 of electrode 22, electrical discharge section 50 positioned at one end is vacuum deposited around the entire circumference in the circumferential direction of cylindrical section 30; the other electrical discharge sections 50 are vacuum deposited extending in the circumferential direction of cylindrical section 30, except for a portion on the opposite side to connecting section 56. Current passing section 60 is formed on the electrical discharge section 50 vacuum deposited across the entire circumference in the circumferential direction of cylindrical section 30 protruding from an end of cylindrical section 30.

Further, the multiple electrical discharge sections 52 of electrode 24 are vacuum deposited on the outer circumferential surface of cylindrical section 30 extending in the circumferential direction, and are arranged lined up in the axis direction of cylindrical section 30 so as to be positioned between the multiple electrical discharge sections 50 of electrode 22. Note that, from among the multiple electrical discharge sections 52 of electrode 24, electrical discharge sections 52 positioned between two of the electrical discharge sections 50 of electrode 22 are vacuum deposited extending in the circumferential direction of cylindrical section 30 excluding connecting section 56 of electrode 22; the remaining electrical discharge sections 52 positioned at the ends are vacuum deposited across the entire circumference in the circumferential direction of cylindrical section 30. Current passing section 62 is formed on the electrical discharge section 52 vacuum deposited across the entire circumference in the circumferential direction of cylindrical section 30 protruding from an end of cylindrical section 30. Also, connecting sections 58 of electrode 24 are vacuum deposited on the outer circumferential surface of cylindrical section 30 extending in a line in the axis direction of cylindrical section 30 at locations where electrical discharge sections 50 of electrode 22 are not vacuum deposited, and are connected to the multiple electrical discharge sections 52. Thus, the pair of electrodes 22 and 24 have electrical discharge sections 50 of electrode 22 and electrical discharge sections 52 of electrode 24 vacuum deposited on the outer circumferential surface of cylindrical section 30 lined up alternately with a specified gap between them.

Note that, although not shown in fig. 2, a glass tube is provided to cover entirely the pair of electrodes 22 and 24 vacuum deposited on the outer circumferential surface of cylindrical section 30. By this, it is possible to prevent exposure of electrodes 22 and 24, through which high voltage is applied, thereby maintaining safety. Note that, because electrodes 22 and 24 are encased by the glass tube, the glass tube encroaches in between electrical discharge sections 50 of electrode 22 and electrical discharge sections 52 of electrode 24.

Gas supply device 28 supplies an inactive gas and a mixed gas that is a mixture of an inactive gas and an active gas and is connected to an end of bent section 32 opposite to an end of bent section 32 that is connected to cylindrical section 30. Thus, the inactive gas and the active gas are supplied inside cylindrical section 30 via bent section 32. Note that, when performing purging as described later, only an inactive gas such as nitrogen or argon is supplied inside container 13, and after purging is completed, only the inactive gas or a mixed gas that is a mixture of a certain ratio of inactive gas and an active gas such as oxygen or hydrogen may be used. Also, processing gas supply device 28 may also be provided with a function to heat or cool the gas, such that the gas can be supplied at a given temperature.

Laser emitting device 14 emits laser light and is substantially a short cylinder. An end surface of laser emitting device 14 is coaxially connected to an end surface of cylindrical section 30 at which bent section 32 is arranged. In a central portion of the end surface of laser emitting device 14 connected to cylindrical section 30, emitting hole 67 is formed, and laser emitting device 14 emits laser light from emitting hole 67 in an axial direction of cylindrical section 30.

Note that, laser light is monochromatic and has directionality and coherence. Directionality means that emitted light travels substantially straight without being spread. Being monochromatic means that the wavelength of the light is narrow, that is, of a single color. Coherence is related to a fixed relationship between the amplitude and phase of two or more waves of light, wherein interference fringes occur when the two or more waves of light interfere. Laser light with such qualities converges in a narrow range. Note that, laser light emitted from laser emitting device 14 is red light with a visible wavelength.

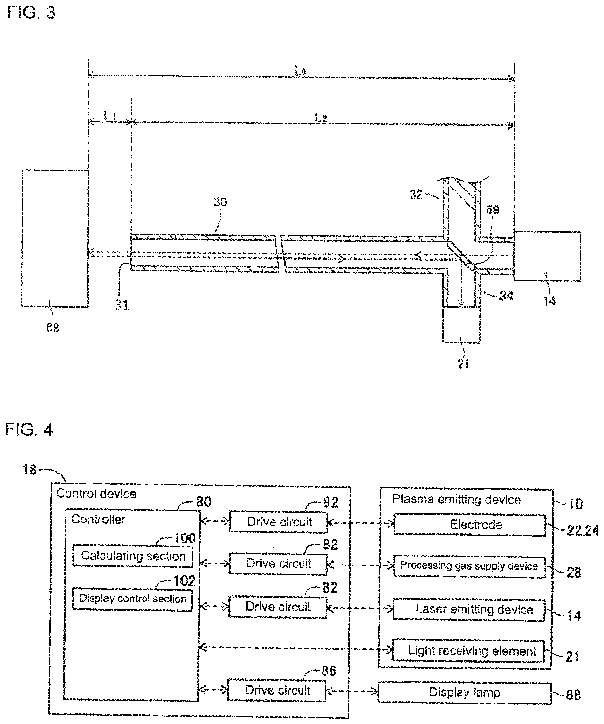

By arranging laser emitting device 14 at an end of cylindrical section 30 of plasma ejecting device 12 in this manner, as shown in fig. 3, laser light emitted from laser emitting device 14 passes through the inside of cylindrical section 30, and is emitted towards the outside of plasma emitting device 10 from the end of cylindrical section 30 opposite to the end at which laser emitting device 14 is provided (also referred to as the "front end" of cylindrical section 30). Thus, laser light emitted by laser emitting device 14 is applied to application target 68 at a position opposite the leading end of cylindrical section 30.

Reflector 69 is arranged inside cylindrical section 30 opposite to dividing section 34. Reflector 69 is arranged at a 45 degree angle with respect to the axis direction of cylindrical section 30, and the reflective surface faces towards dividing section 34. Note that, the reflectance of reflector 69 is 50%, and the permeability is 50%. Therefore, 50% of the laser light emitted from laser emitting device 14 passes through reflector 69 and is emitted outside of plasma emitting device 10. Therefore, 50% of the laser light emitted from laser emitting device 14 is applied to application target 68. Light applied to application target 68 is reflected by application target 68, and that reflected light is reflected inside cylindrical section 30 coaxially to the laser light emitted from laser light emitting device 14. The reflected light that goes through the inside of cylindrical section 30 is reflected by reflector 69 and goes through the inside of dividing section 34. The reflected light is then detected by light receiving element 21 and the distance between plasma emitting device 10 and application target 68 is calculated based on the detected light. Details about calculation of the distance between plasma emitting device 10 and application target 68 are described later.

As shown in fig. 4, control device 18 is provided with controller 80, multiple drive circuits 82, and control circuit 86. The multiple drive circuits 82 are connected to the electrodes 22 and 24, processing gas supply device 28, and the laser emitting device 14. Controller 80 is provided with a CPU, ROM, RAM, and so on, is formed mainly from a computer, and is connected to the multiple drive circuits 82. By this, operation of plasma emitting device 10 is controlled by controller 80. Controller 80 is also connected to light receiving element 21. Controller 80 acquires information related to light received by light receiving element 21. Controller 80 is also connected to display lamp 88 via control circuit 86. Display lamp 88 is a lamp that displays a red or green light and controller 80 causes display lamp 88 to shine red or green. With the present invention, laser emitting device 14 and lighting receiving element 21 are not essential and may be provided as necessary.

In embodiments not being part of the invention, the shape and material of container 13 are not particularly limited so long it is possible to block the atmosphere surrounding plasma emission port 31 by covering application target 68. Note that, in a case in which plasma emitting device 10 shown in fig. 1 is to be used for medical treatment by emitting plasma to a body part requiring treatment as application target 68, it is desirable to be able to adjust the interval between the body part and plasma emission port 31. Therefore, an interval adjusting mechanism for adjusting the interval between application target 68 and plasma emission port 31 is provided in accordance with the present invention.

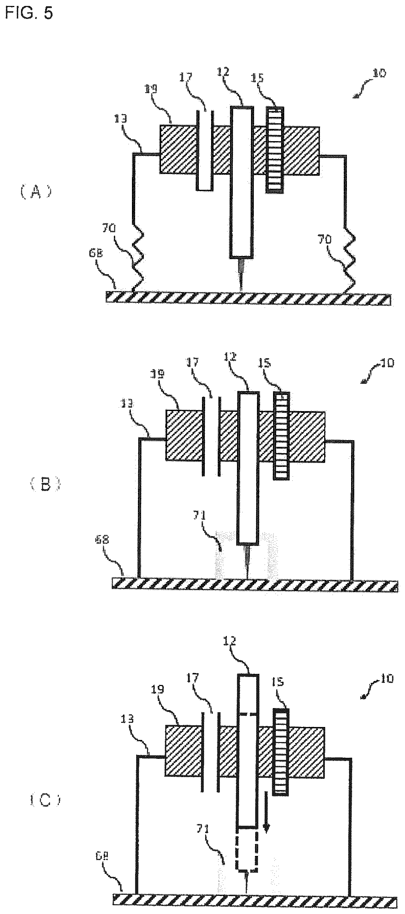

The interval adjusting mechanism is capable of adjusting the interval between application target 68 and plasma emission port 31. Fig. 5(A) shows an example of an interval adjusting mechanism being part of the present invention, which by pressing at least a portion of container 13 is able to change shape, for example, accordion-shape section 70. Note that, any shape may be used so long as the shape changes by pressing. Also included as an interval adjusting mechanism being part of the present invention is a configuration in which container 13 is formed from a flexible material such as silicone, such that the entire body of container 13 bends when plasma emitting device 10 is pressed against application target 68, so as to adjust the interval between a body part requiring treatment and plasma emission port 31.

Fig. 5(B) shows another example of an interval adjusting mechanism being part of the present invention, in which application distance fixing attachment 71 is attached near to plasma emission port 31 of plasma ejecting device 12. In the example shown in fig. 5(B), because application distance fixing attachment 71 is fixed to plasma ejecting device 12, by contacting application distance fixing attachment 71 against application target 68 it is possible to maintain a fixed distance between plasma emission port 31 and application target 68. Note that, in the example shown in fig. 5(B), it is appropriate that the surface of the opening section of container 13 and the tip end of application distance fixing attachment 71 are at the same level. In this case, the container 13 may be formed, in embodiments which are not covered by the present invention, from a material that does not change shape, for example, stainless steel or glass. Also, in a case in which the tip end of application distance fixing attachment 71 is positioning further inside container 13 than the surface at the opening section of container 13, as shown in fig. 5(A), container 13 is formed, in accordance with the invention, from a material or shape that can change shape.

Fig. 5(C) shows another example of an interval adjusting mechanism being part of the present invention, in which plasma ejecting device 12 is movable with respect to container attachment frame 19. In this case, in embodiments which are not covered by the present invention, the container 13 may be formed from a material that does not change shape, for example, stainless steel or glass. Also, application distance fixing attachment 71 may be attached close to plasma emission port 31 of plasma ejecting device 12.

As described above, the interval adjusting mechanism of the device of the present invention is provided based on a combination of: container 13 formed from a shape or material that can change shape; attaching application distance fixing attachment 71; and making plasma ejecting device 12 movable with respect to container attachment frame 19.

In accordance with the present invention, the configuration of gas sensor 15 is not particularly limited so long as it can measure the concentration of an active gas inside container 13. In the present invention, as described later, because the inside of container 13 is purged with inactive gas, for example, in a case in which argon is used as the inactive gas, an argon sensor is used, and in a case in which nitrogen is used as the inactive gas, a nitrogen sensor is used, so as to confirm that the inactive gas has replaced another gas inside container 13. Also, purging is performed to lower the concentration of active gas such as oxygen inside container 13. Thus, an active gas sensor such as an oxygen sensor may be used as gas sensor 15.

Gas ejection hole 17 is for ejecting gas that is inside container 13 outside when the oxygen concentration inside container 13 has been lowered by inserting inactive gas into container after contacting container 13 against application target 68. In the embodiment of fig. 1, gas ejection hole 17 is formed as a hollow pipe piercing container attachment frame 19, but the configuration is not particularly limited so long as gas inside container 13 can be ejected, for example, gas ejection hole 17 may be formed in a portion of container 13. Also, a cutout may be formed in opening section 131 of container 13 such that a gap is formed between container 13 and application target 68 when container 13 contacts against application target 13, wherein the gas is ejected via the gap. In this case, gas ejection hole 17 is not required.

The configuration of container attachment frame 19 is not particularly limited so long as attachment of plasma ejecting device 12, gas sensor 15, gas ejection hole 17, and container 13 is possible, and may be formed from stainless steel or the like. Note that, in a case in which container 13 is formed, as in the embodiments which are not part of the present invention, from a material that does not change shape such as stainless steel or glass, items such as plasma ejecting device 12, gas sensor 15, and gas ejection hole 17 may be attached directly to container 13 without the need for container attachment frame 19. The embodiments of the present invention are however provided with a container attachment frame 19.

Plasma application method using plasma emitting device

According to the above configuration, with plasma emitting device 10, plasma is ejected from plasma emission port 31 of plasma ejecting device 12 to be applied to application target 68. Plasma includes active radicals and is used in medical fields for the purpose of treating an affected body part with active radicals. Specifically, for example, by using oxygen as an active gas, oxygen plasma is applied to application target 68. Oxygen plasma is effective at killing cells, and, for example, by applying the oxygen plasma to cancerous cells, can be used for the purpose of cancer treatment. Also, for example, by using hydrogen as an active gas, hydrogen plasma can be applied to application target 68. Hydrogen plasma is effective for regenerating cells, and, for example, by applying the hydrogen plasma to skin, can be used for the purpose of skin regeneration treatment. However, therapeutic methods of the human and animal body are not covered by the present invention.

Specifically, first, opening section 131 of container 13 covers application target 68. The interval between plasma emission port 31 and application target 68 may be adjusted at this stage, or may be adjusted before performing the plasma ejecting, which is described later. Next, inactive gas from processing gas supply device 28 is inserted into container 13 from plasma emission port 31 after passing through cylindrical section 30 via bent section 32. Because atmospheric air inside container 13 is ejected from gas ejection hole 17 or from the gap between container 13 and application target 68, the atmospheric air inside container 13 is purged by the inactive gas, which lowers the oxygen concentration (purging). Note that, the atmosphere inside container 13, specifically the concentration of atmospheric air in accordance with the present invention, during purging is monitored by gas sensor 15 (atmosphere measurement). Moreover, in accordance with the invention, after using gas sensor 15 to confirm that the oxygen concentration has reached a given level, plasma ejecting is performed. Note that, during plasma ejecting, gas supplied from processing gas supply device 28 may be only inactive gas, or may be a mixed gas with a specified concentration of active gas such as hydrogen.

Plasma ejecting is performed by applying a voltage to current passing sections 60 and 62 of electrodes 22 and 24 such that current flows through electrodes 22 and 24 while the inactive gas or mixed gas is flowing through cylindrical section 30 on which electrodes 22 and 24 are vacuum deposited. By this, electrical discharge is generated between electrical discharge sections 50 and 52 of the pair of electrodes 22 and 24. Here, because electrodes 22 and 24 are encased by glass tube 26, which is an insulating body, electrical discharge is generated inside cylindrical section 30 such that the inactive gas or mixed gas flowing inside cylindrical section 30 is plasmarized. This plasma is ejected from plasma emission port 31 in an axial direction of cylindrical section 30. Here, in embodiments which are not covered by the present invention, a person giving treatment, such as a doctor, points the plasma emission port towards the affected body part of the patient to treat the affected body part by applying plasma.

Note that, when plasma is applied to the affected body part, as done in the embodiments not covered by the present invention, the concentration of active radicals in the applied plasma should be appropriate in order to perform appropriate treatment, therefore the concentration of active gas in the mixed gas supplied from processing gas supply device 28 is appropriately controlled. If the plasma comes into contact with air, active radicals will deactivate, and the concentration of plasma active radicals applied to the affected body part may change. However, with the present invention, because atmospheric air between plasma emission port 31 and application target 68 has been purged in advance by an inactive gas, plasma is maintained at a constant level.

Note that, because the wavelength of the plasma is in a vacuum ultraviolet range, it cannot be checked visually. Therefore, since, in accordance with the present invention, an application distance fixing attachment 71 is provided, the configuration may be set in advance such that the interval between plasma emission port 31 and application target 68 is favorable. On the other hand, if application distance fixing attachment 71 is not provided, as in the embodiments which are not covered by the present invention, it may be difficult to apply plasma appropriately. Considering this, as necessary, plasma emitting device 10 may be provided with laser emitting device 14, and by the laser light emitted by laser emitting device 14, the application position of the plasma can be checked.

In detail, as described above, laser emitting device 14 is connected to an end surface of cylindrical section 30 of plasma ejecting device 12, and emits laser light in an axial direction of cylindrical section 30. That is, laser emitting device 14 emits laser light coaxially with the emission direction of plasma. Also, laser light is directional light that travels straight. Thus, the laser light emitted from laser emitting device 14 passes through cylindrical section 30 and is emitted from the plasma emission port of cylindrical section 30 coaxially to the ejection direction of the plasma. By this, as shown in fig. 3, laser light is applied to a location to which the plasma is applied. Because the laser light is red laser light of a high frequency in a visible range, the person providing treatment is able to appropriately apply plasma to the application target 68 while visually checking the laser light.

However, if the application target 68 to which plasma is to be applied is too far away from plasma emitting device 10, the plasma may not reach the application target 68, thereby lowering the effectiveness of the plasma treatment. On the other hand, it is undesirable for the application target 68 to be too close to plasma emitting device 10 if the plasma is hot. Thus, it is desirable to make the distance between plasma emitting device 10 and application target 68 appropriate (also referred to as the "application target separation distance") when applying plasma to the application target 68. Therefore, with plasma emitting device 10, the application target separation distance is calculated using the laser light that is used for checking the application position of the plasma.

In detail, plasma emitting device 10 is provided with light receiving element 21 and, as shown in fig. 3, laser light emitted towards application target 68 from laser emitting device 14 is reflected and the reflected light is received by light receiving element 21. AM (amplitude modulation) is performed on the laser light emitted from laser emitting device, and the amplitude of amplitude modulated laser light changes over time. Therefore, a phase difference arises between a wave of laser light emitted from laser emitting device 14 and a wave of laser light received by laser receiving element 21, with that phase difference being calculated by controller 80. The phase difference is proportional to the travel distance of the light received by light receiving element 21 that was emitted from laser emitting device 14 towards application target 68 and reflected by application target 68, that is, is proportional to the emission distance of the laser light (also referred to as "laser emission distance").

Note that, the distance between laser emitting device 14 and reflector 69 is the same as the distance between reflector 69 and light receiving element 21. Therefore, the laser emission distance is $2 \times L_0$, and controller 80 calculates the laser emission distance ($2 \times L_0$) based on the phase difference. Length $L_2$ of cylindrical section 30 is memorized in controller 80. Therefore, by subtracting the length of cylindrical section 30 ($L_2$) from half of the laser emission distance ($2 \times L_0$), distance L1 between the plasma emission port of cylindrical section 30 and application target 68, that is, the application target separation distance, can be calculated.

In controller 80, after the application target separation distance is calculated, it is determined whether the application target separation distance is within a predetermined set range. If the calculated application target separation distance is within the set range, controller 80 causes display lamp 88 to display a green light; if the calculated application target separation distance is not within the set range, controller 80 causes display lamp 88 to display a red light. The set range can be entered by an operator via an input device (not shown) and can be set to any range. Therefore, by entering an appropriate range for plasma treatment as the set range, an operator can guarantee appropriate plasma treatment. That is, a person giving treatment can move plasma emitting device 10 towards the affected body part (which in accordance with the invention does not belong to the human or animal body), that is, application target 68, while applying plasma to the application target 68 such that a green light is always displayed by display lamp 88, thereby guaranteeing appropriate plasma treatment. Also, measurement values of gas sensor 15 may be sent to control device 18, and control performed such that a lamp displays when the atmosphere inside container 13 reaches a value set in advance.

In this manner, with plasma emitting device 10, it is possible to check the plasma application position using the laser light. Also, the application target separation distance can be calculated using the laser light used for checking the plasma application position, and whether the application target separation distance is appropriate can be reported to the person performing treatment. Thus, even if an application distance fixing attachment is not provided, as done in the embodiments not covered by the present invention, the person performing treatment can perform treatment while checking the plasma application position and the plasma emission distance, thereby guaranteeing appropriate plasma treatment.

Also, by using the laser light used for checking the plasma application position, costs are greatly reduced. Also, as described above, the laser light is emitted coaxially with the emission axis of the plasma, and the application target separation distance is calculated based on the laser light emission distance. Therefore, the calculated application target separation distance matches the plasma emission distance, so the plasma emission distance can be calculated accurately.

Note that, as shown in fig. 4, controller 80 of control device 18 includes calculating section 100 and display control section 102. Calculating section 100 is for calculating the application target separation distance. Display control section 102 is for causing display lamp 88 to display a light based on the calculated application target separation distance, and acts as the functional section for reporting the application target separation distance to the person performing treatment.

Further, the present invention is not limited to the above example embodiments, and various embodiment are possible without departing from the scope of the invention as determined by the appended claims. Specifically, for example, in an embodiment above, whether the calculated application target separation distance is within a set range is reported to a person performing treatment using display lamp 88, but this may be reported by displaying the value of the calculated application target separation distance, or by outputting audio of the value of the calculated application target separation distance.

Also, in an embodiment above, the application target separation distance is calculated using the phase difference between laser light emitted by laser emitting device 14 and laser light received by light receiving element 21, but the application target separation distance may be calculated using the time lag between the emission timing of the laser light by laser emitting device 14 and the receiving timing of the laser light by light receiving element 21. Specifically, laser emitting device 14 may emit laser light with a predetermined pulse width and the emission time may be memorized. Also, the receiving time at which light receiving element 21 receives the reflected light may be memorized. Then, the difference between the emission time and the receiving time may be calculated as time lag $\Delta t$, and laser emission distance ($2 \times L_0$) may be calculated using time lag $\Delta t$ according to the formula below.

$$2 \times L_0 = c \times \Delta t$$

wherein c is the speed of light

Once the laser emission distance ($2 \times L_0$) has been calculated, application target separation distance L1 can be calculated in a similar manner to that described above.

Further, in an embodiment above, laser light is used as light applied to application target 68, but various types of light may be used, so long as the light is visible. However, to appropriately check the plasma application position, it is desirable to appropriately calculate the application target separation distance using reflected light, thus it is desirable to use light with excellent straightness and convergence properties, that is, so-called directional light.

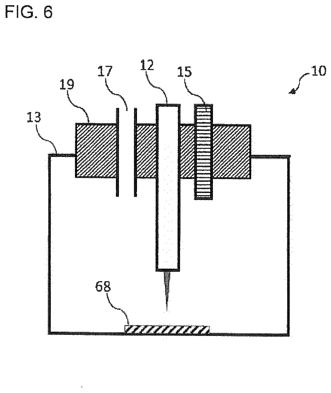

Also, because plasma emitting device 10 of the present invention is capable of applying a constant level of plasma to application target 68, usage is not limited to medical fields (treatments) and plasma emitting device 10 may be used for processing of materials and the like that require plasma processing. Fig. 6 shows another embodiment of plasma emitting device 10, and except for the point that opening section 131 is not formed in container 13, is the same as plasma emitting device 10 shown in figs. 1 to 5. With the embodiment shown in fig. 6, container attachment frame 19 and container 13 are detachable, and application target 68 may be loaded onto container 13 while container 13 is in a detached state. Alternatively, container 13 may have a door member, not shown, that opens and closes to allow application target 68 to be put in and taken out. The door member may be closely fitted on container 13 or may be configured with a slight gap to allow gas inside container 13 to escape. If a gap is provided, gas ejection hole 17 is not required. For the embodiment shown in fig. 6, because a constant level of plasma is applied to application target 68, it is possible to guarantee a constant level of quality for each product in a case in which plasma processing is performed on multiple application targets 68.

Reference Signs List

10: plasma emitting device;
12: plasma ejecting device;
13: container;
14: laser emitting device (light emitting device);
15: gas sensor;
17: gas exhaust port;
18: control device;
19: container attachment frame;
20: main body section;
21: light receiving element (light receiver);
22, 24: electrode;
28: processing gas supply device;
30: cylindrical section (inner housing);
31: plasma emission port;
32: bent section;
34: dividing section;
50, 52: electrical discharge section;
56, 58: connecting section;
67: emitting hole;
68: target body;
69: half-mirror;
70: accordion-shape section;
71: application distance fixing attachment;
80: controller;
82: drive circuit;
86: control circuit;
88: display lamp;
100: calculating section (calculating device)
102: display control section;
131: opening section

**Claims**

1. A plasma emitting device (10) comprising:

   a plasma ejecting device (12) configured to eject plasma;
   a container (13) arranged such that at least a plasma emission port (31) of the plasma ejecting device (12) is inside the container (13);
   a container attachment frame (19) to which the plasma ejecting device (12) is attached;
   a processing gas supply device (28) configured to supply an inactive gas and a mixed gas that is a mixture of an inactive and an active gas;
   an interval adjusting mechanism configured to adjust an interval between a target body (68) and the plasma emission port (31) arranged inside the container (13), and
   the interval adjusting mechanism is formed from a shape or material that enables the container (13) to change shape, and adjusts the interval by changing the shape of the container (13), **characterized by:**

   the plasma ejecting device (12) being movable with respect to the container attachment frame (19), a gas sensor (15) configured to measure concentrations of the active gas inside the container (13), the interval adjusting mechanism including an application distance fixing attachment (71) that is attached close to the plasma emission port (31) of the plasma ejecting device.

2. The plasma emitting device (10) according to claim 1, further including
a gas exhaust port (17) through which gas inside the container (13) is ejected.

3. The plasma emitting device (10) according to any one of claims 1 and 2, wherein
an opening section (131) that opens in a direction in which the plasma is ejected from the plasma ejecting device (12) is formed in the container (13).

4. The plasma emitting device (10) according to any one of claims 1 to 3, wherein
the gas sensor (15) is an oxygen sensor.

5. A plasma application method for applying plasma to a processing target (excluding the animal and human body) using the plasma emitting device (10) according to any one of the claims 1 to 4, the plasma application method including:

performing purging that lowers an oxygen concentration in the container (13) by emitting inactive gas into the container (13);
performing atmosphere measurement to measure concentrations of atmospheric air inside the container (13) during the purging; and
ejecting plasma towards the processing target from the plasma ejecting device (12) after the oxygen concentration inside the container (13) measured during the atmosphere measurement has reached a desired value.

**Patentansprüche**

1. Eine Plasmastrahlungsvorrichtung (10) umfassend:

eine Plasmaemissionsvorrichtung (12), die zum Ausstoßen von Plasma konfiguriert ist;
einen Behälter (13), der so angeordnet ist, dass sich mindestens eine Plasmaemissionsöffnung (31) der Plasmaemissionsvorrichtung (12) innerhalb des Behälters (13) befindet;
einen Behälterbefestigungsrahmen (19), an dem die Plasmaemissionsvorrichtung (12) befestigt ist;
eine Prozessgaszufuhrvorrichtung (28), die konfiguriert ist ein inaktives Gas und ein Mischgas, das eine Mischung aus einem inaktiven und einem aktiven Gas ist, zuzuführen;
einen Abstandseinstellmechanismus, der konfiguriert ist einen Abstand zwischen einem Zielkörper (68) und der Plasmaemissionsöffnung (31) einstellt, die im Inneren des Behälters (13) angeordnet ist, und
der Abstandseinstellmechanismus aus einer Form oder einem Material gebildet ist, das es dem Behälter (13) ermöglicht, seine Form zu ändern, und den Abstand durch Ändern der Form des Behälters (13) einzustellt
**gekennzeichnet durch:**

die Plasmaemissionsvorrichtung (12), die in Bezug auf den Behälterbefestigungsrahmen (19) beweglich ist,
ein Gassensor (15), der konfiguriert ist die Konzentrationen des aktiven Gases im Inneren des Behälters (13) zu messen, und
den Abstandseinstellmechanismus, der eine Befestigungsvorrichtung für den Applikationsabstand (71) umfasst, die in der Nähe der Plasmaemissionsöffnung (31) der Plasmaemissionsvorrichtung (12) angebracht ist.

2. Die Plasmastrahlungsvorrichtung (10) gemäß Anspruch 1, des Weiteren umfassend
eine Gasauslassöffnung (17), durch die Gas aus dem Inneren des Behälters (13) ausgestoßen wird.

3. Die Plasmastrahlungsvorrichtung (10) gemäß Anspruch 1 oder 2, wobei
in dem Behälter (13) ein Öffnungsabschnitt (131) ausgebildet ist, der sich in einer Richtung öffnet, in der das Plasma aus der Plasmaemissionsvorrichtung (12) ausgestoßen wird.

4. Die Plasmastrahlungsvorrichtung (10) gemäß einem der Ansprüche 1 bis 3, wobei
der Gassensor (15) ein Sauerstoffsensor ist.

5. Ein Plasmaapplikationsverfahren zum Aufbringen von Plasma auf ein Bearbeitungsziel (mit Ausnahme eines menschlichen Körpers) unter Verwendung der Plasmastrahlungsvorrichtung (10) nach einem der Ansprüche 1 bis 4, wobei das Plasmaapplikationsverfahren Folgendes umfasst:

Durchführen einer Spülung, die eine Sauerstoffkonzentration in dem Behälter (13) senkt, indem inaktives Gas in den Behälter (13) abgegeben wird;
Durchführen einer Atmosphärenmessung, um die Konzentrationen der atmosphärischen Luft im Inneren des Behälters (13) während des Spülens zu messen; und
Ausstoßen von Plasma in Richtung des Bearbeitungsziels aus der Plasmaemissionsvorrichtung (12), nachdem die Sauerstoffkonzentration im Inneren des Behälters (13), die während der Atmosphärenmessung gemessen wurde, einen gewünschten Wert erreicht hat.

**Revendications**

1. Dispositif d'émission de plasma (10) comprenant :

un dispositif d'éjection de plasma (12) configuré pour éjecter du plasma ;
un conteneur (13) agencé de telle sorte qu'au moins un orifice d'émission de plasma (31) du dispositif d'éjection de plasma (12) se trouve à l'intérieur du conteneur (13) ;
un châssis d'attache de conteneur (19) auquel le dispositif d'éjection de plasma (12) est attaché ;
un dispositif d'alimentation de gaz de traitement (28) configuré pour alimenter un gaz inactif et un gaz mélangé, qui est un mélange de gaz inactif et de gaz actif ;
un mécanisme d'ajustement d'intervalle configuré pour ajuster un intervalle entre un corps cible (68) et l'orifice d'émission de plasma (31) agencé à l'intérieur du conteneur (13),
le mécanisme d'ajustement d'intervalle comportant une forme ou un matériau qui permet au conteneur (13) de changer de forme, et ajustant l'intervalle en changeant la forme du conteneur (13),
**caractérisé en ce que :**

le dispositif d'éjection de plasma (12) est mobile par rapport au châssis d'attache de conteneur (19),
un capteur de gaz (15) est configuré pour mesurer les concentrations du gaz actif à l'intérieur du conteneur (13),
le mécanisme d'ajustement d'intervalle comporte une attache pour fixer la distance d'application (71) qui est attachée près de l'orifice d'émission de plasma (31) du dispositif d'éjection de plasma.

2. Dispositif d'émission de plasma (10) selon la revendication 1, comprenant en outre
un orifice d'évacuation de gaz (17) à travers lequel le gaz présent à l'intérieur du conteneur (13) est éjecté.

3. Dispositif d'émission de plasma (10) selon l'une quelconque des revendications 1 et 2, dans lequel une section d'ouverture (131) qui s'ouvre dans une direction dans laquelle le plasma est éjecté du dispositif d'éjection de plasma (12) est formée dans le conteneur (13) .

4. Dispositif d'émission de plasma (10) selon l'une quelconque des revendications 1 à 3, dans lequel le capteur de gaz (15) est un capteur d'oxygène.

5. Procédé d'application de plasma destiné à appliquer un plasma sur une cible de traitement (excluant un corps animal ou humain) à l'aide d'un dispositif d'émission de plasma (10) selon l'une quelconque des revendications 1 à 4, le procédé d'application de plasma comprenant :

la mise en oeuvre d'une purge qui abaisse la concentration d'oxygène dans le conteneur (13) en émettant un gaz inactif dans le conteneur (13) ;
la mise en oeuvre de mesures d'atmosphère pour mesurer la concentration d'air atmosphérique à l'intérieur du conteneur (13) durant la purge ; et
l'éjection de plasma vers la cible de traitement par le dispositif d'éjection de plasma (12) après que la concentration d'oxygène à l'intérieur du conteneur (13) mesurée durant la mesure d'atmosphère a atteint une valeur désirée.

FIG. 1

FIG. 2

FIG. 3

FIG. 4

FIG. 5

(A)

(B)

(C)

FIG. 6

## REFERENCES CITED IN THE DESCRIPTION

### Patent documents cited in the description

- WO 2013108797 A
- WO 2012005132 A
- JP 2002241947 A
- DE 102013113941 A1
- EP 3054032 A1